(19) Europäisches Patentamt
European Patent Office
Office européen des brevets

(11) **EP 1 070 371 B1**

(12) **FASCICULE DE BREVET EUROPEEN**

(45) Date de publication et mention
de la délivrance du brevet:
**13.08.2008 Bulletin 2008/33**

(51) Int Cl.:
*H01S 5/183* *(2006.01)*  *G02B 7/00* *(2006.01)*
*H01L 21/762* *(2006.01)*  *H01L 33/00* *(2006.01)*

(21) Numéro de dépôt: **00901720.3**

(22) Date de dépôt: **07.02.2000**

(86) Numéro de dépôt international:
**PCT/FR2000/000278**

(87) Numéro de publication internationale:
**WO 2000/048278 (17.08.2000 Gazette 2000/33)**

(54) **PROCEDE DE FORMATION SUR UN SUPPORT D'UNE COUCHE DE SILICIUM A USAGE OPTIQUE ET MISE EN OEUVRE DU PROCEDE POUR LA REALISATION DE COMPOSANTS OPTIQUES**

HERSTELLUNGSVERFAHREN EINER SILICIUM SCHICHT AUF EINEM TRÄGER FÜR OPTISCHE ZWECKE UND DESSEN UMSETZUNG ZUR HERSTELLUNG VON OPTISCHEN KOMPONENTEN

METHOD FOR FORMING AN OPTICAL SILICON LAYER ON A SUPPORT AND USE OF SAID METHOD IN THE PRODUCTION OF OPTICAL COMPONENTS

(84) Etats contractants désignés:
**DE DK GB IT NL SE**

(30) Priorité: **10.02.1999   FR 9901559**

(43) Date de publication de la demande:
**24.01.2001   Bulletin 2001/04**

(73) Titulaire: **COMMISSARIAT A L'ENERGIE ATOMIQUE**
**75015 Paris (FR)**

(72) Inventeurs:
• **HADJI, Emmanuel**
  **F-38600 Fontaine (FR)**

• **PAUTRAT, Jean-Louis**
  **F-38100 Grenoble (FR)**

(74) Mandataire: **Weber, Etienne Nicolas et al**
**Brevatome**
**3, rue du Docteur Lancereaux**
**75008 Paris (FR)**

(56) Documents cités:
**EP-A- 0 578 407     US-A- 5 363 398**
**US-A- 5 374 564**

## Description

Domaine technique

L'invention concerne un procédé de formation sur un support d'une couche de silicium à usage optique ainsi qu'un certain nombre d'applications du procédé pour la réalisation de composants optiques.

On entend par couche de silicium à usage optique une couche qui dans un composant optique contribue à la conduction, à la réflexion, à la transmission et/ou à la génération de la lumière.

L'invention trouve des applications notamment dans la fabrication de miroirs, tels que des miroirs de Bragg ainsi que dans la fabrication de cellules d'émetteurs optiques à microcavité.

Etat de la technique antérieure

Le silicium est un matériau largement utilisé dans la fabrication de circuits de microélectronique.

Dans le domaine optique, par contre, la bande interdite indirecte du silicium, lui confère de très faibles propriétés radiatives qui rendent impossible l'utilisation de ce matériau tel quel pour émettre de la lumière.

A l'heure actuelle, il n'existe pas sur le marché de dispositifs émetteurs de lumière à base de silicium.

De tels émetteurs seraient cependant avantageux car les technologies liées au silicium sont particulièrement développées et, de ce fait, peu onéreuses.

De plus, il serait possible d'associer des composants optiques à des composants électroniques et les intégrer dans les circuits de microélectronique.

On connaît un certain nombre d'utilisations d'autres semi-conducteurs, principalement de type III-V, pour la fabrication de microcavités. Les microcavités comportent un milieu actif sous la forme d'une couche dont l'épaisseur est un multiple de la demi-longueur d'onde de la lumière de travail, et sont disposés en sandwich entre un premier et un deuxième miroirs.

Le document (1) dont la référence est précisée à la fin de la présente description, concerne la fabrication de microcavités du type de Fabry-Pérot à base de silice amorphe dopée à l'erbium.

Les micro-cavités sont délimitées par deux miroirs de Bragg.

Le caractère amorphe des matériaux utilisés pour la réalisation de ces microcavités diminue fortement les possibilités d'émission de lumière. En revanche, l'incorporation d'ions de terres rares permet l'usage de telles microcavités.

Le document (2) dont la référence est également précisée à la fin de la description, montre un procédé de formation sur un raidisseur d'une couche mince de silicium présentant une épaisseur déterminée, comportant le collage moléculaire sur le raidisseur d'une plaquette de silicium comprenant une couche superficielle délimitée par une zone de clivage parallèle à sa surface, et le bloc de silicium étant recouvert d'une couche encapsulante d'oxyde de silicium thermique, mise en contact avec le raidisseur lors du collage. La zone de clivage est créée dans la plaquette à une profondeur déterminée correspondant à ladite épaisseur déterminée, par une étape d'implantation par bombardement de la face de la plaquette de silicium au moyen d'ions de gaz hydrogène (à travers la couche encapsulante d'oxyde de silicium thermique). Ensuite, la couche superficielle est détachée de la plaquette, solidaire du raidisseur, par clivage, selon la zone de clivage, assisté par un traitement thermique.

Exposé de l'invention

La présente invention a pour but de proposer un procédé de formation d'une couche de silicium et en particulier une couche de silicium cristallin en vue de la réalisation de composants optiques et en particulier de sources d'émission de lumière à microcavité.

Un but est également de proposer un tel procédé qui permette la fabrication de composants optiques à un coût particulièrement réduit.

Un autre but encore de proposer ledit procédé dans des applications à la fabrication de miroirs de Bragg et à des émetteurs optiques à microcavité.

Pour atteindre ces buts, l'invention a plus précisément pour objet un procédé de formation sur un support d'une couche de silicium à usage optique présentant une épaisseur (optique) déterminée. Conformément à l'invention, le procédé comporte les étapes successives suivantes :

a) le collage moléculaire sur le support, déjà équipé ou non d'autres couches, d'un bloc de silicium, le bloc de silicium comprenant une couche superficielle, délimitée par une zone de clivage sensiblement parallèle à sa surface, et présentant une épaisseur supérieure, respectivement inférieure à ladite épaisseur déterminée, et le bloc de silicium étant recouvert d'une couche d'oxyde de silicium, mise en contact avec le support lors du collage,

b) le clivage du bloc de silicium selon la zone de clivage pour en détacher la couche superficielle solidaire du support,

c) l'amincissement, respectivement l'augmentation de l'épaisseur, de ladite couche superficielle jusqu'à atteindre une épaisseur sensiblement égale à ladite épaisseur déterminée.

On entend par collage moléculaire un collage impliquant des liaisons moléculaires entre les surfaces en contact, sans interposition de liant.

La mise en oeuvre d'une technique de clivage est bien connue dans le domaine de la microélectronique et est décrite par exemple dans le document (3) dont la référence est précisée à la fin de la description. Cette technique permet de former efficacement une couche de silicium, notamment une couche de silicium cristallin, à la surface d'un support, et en particulier sur un support ne présentant pas la même maille cristalline ou la même structure cristalline que le silicium.

Or, le procédé de l'invention permet de mettre en oeuvre dans le domaine optique le procédé de clivage en dépit des limitations mentionnées ci-dessus.

Selon une première possibilité de mise en oeuvre du procédé, lors de l'étape a), la couche superficielle présente une épaisseur supérieure à l'épaisseur déterminée. Dans ce cas, l'étape c) comporte un amincissement par voie mécanique, chimique ou mécanochimique de cette couche.

En particulier, la couche de silicium peut être amincie par polissage ou par un traitement associant une oxydation en surface de la couche et une élimination sélective, par gravure, de l'oxyde.

Selon une deuxième possibilité, on peut également utiliser lors de l'étape a) un bloc de silicium dont la couche superficielle, délimitée par la zone de clivage, présente une épaisseur qui est inférieure à l'épaisseur déterminée. Dans ce cas, lors de l'étape c), on augmente l'épaisseur de la couche superficielle par croissance cristalline.

La croissance cristalline a lieu par exemple selon un procédé tel que l'épitaxie en phase vapeur.

Avant l'étape de collage, le bloc de silicium peut être préparé en effectuant une implantation d'hydrogène à travers une de ses faces pour former une zone fragilisée, s'étendant sensiblement selon un plan parallèle à ladite face et formant la zone de clivage. L'énergie de l'implantation est ajustée pour former la zone de clivage à une profondeur qui, selon le mode de mise en oeuvre sélectionné, est soit supérieure, soit inférieure, à ladite épaisseur déterminée.

L'épaisseur déterminée est comprise ici comme une épaisseur de la couche (superficielle) de silicium permettant d'obtenir un comportement optique déterminé. Il s'agit par exemple d'une épaisseur égale où proportionnelle à $\dfrac{\lambda}{4n_s}$ ou $\lambda$ est la longueur de travail de la lumière produite ou reçue et $n_s$ l'indice de réfraction du silicium.

Selon une mise en oeuvre préférentielle une couche d'oxyde de silicium est formée sur le bloc de silicium, et plus précisément sur la face d'implantation. Cette couche formée préférentiellement avant l'implantation, vient alors en contact du support lors de l'étape de collage moléculaire du procédé de l'invention.

Une application particulière de l'invention concerne un procédé de fabrication d'un miroir de Bragg de longueur d'onde $\lambda$, sur un support. Selon ce procédé, on forme un empilement de couches comprenant alternativement au moins une couche d'oxyde de silicium d'épaisseur optique $\dfrac{\lambda}{4n_o}$, où $n_o$ désigne l'indice de réfraction de l'oxyde de silicium et au moins une couche de silicium présentant une épaisseur optique $\dfrac{\lambda}{4n_s}$, où $n_s$ désigne l'indice de réfraction du silicium, et ladite couche de silicium étant formée selon le procédé évoqué ci-dessus.

La couche d'oxyde peut être, par exemple, la couche d'oxyde évoquée ci-dessus et formée sur le bloc de silicium avant l'implantation.

Le miroir de Bragg comporte de préférence une pluralité de périodes, c'est-à-dire une pluralité de couches de silicium respectivement alternées avec une pluralité de couches d'oxyde de silicium.

Les couches d'oxyde de silicium peuvent être formées, par exemple, par dépôt chimique en phase vapeur, selon une technique de dépôt assisté par plasma, désignée par PECVD (Plasma Enhanced Chemical Vapor Deposition - dépôt chimique en phase vapeur assisté par plasma).

Une autre application particulière de l'invention est un procédé de fabrication d'un composant optique avec une longueur d'onde de travail $\lambda$ comprenant :

- la formation d'un miroir de Bragg selon le procédé mentionné ci-dessus,
- la formation par croissance cristalline sur le miroir de Bragg d'une couche de matériau actif pour former une cavité,
- la formation sur la cavité d'un second miroir.

Le matériau actif peut être du silicium cristallin pur ou contenant un élément actif tel que des impuretés d'erbium ou de néodyme par exemple.

Le matériau actif peut également être un alliage SiGe, SiGeC ou SiC sous forme de film mince, sous forme de structure à boîtes quantiques ou de structure multicouches avec plusieurs films de matériaux différents.

On entend par structure à boîtes quantiques une matrice d'un premier matériau contenant des inclusions nanométriques d'un second matériau, le second matériau ayant une largeur de bande interdite plus faible que celle du premier matériau. Le ou les matériau(x) de la cavité peu(ven)t être formé(s), par exemple, par croissance cristalline en phase vapeur ou par jet moléculaire. Leur épaisseur, ou tout au moins l'épaisseur de la cavité, est ajustée pour correspondre à une épaisseur optique souhaitée en fonction d'une longueur d'onde de travail donnée.

Le second miroir, qui recouvre la cavité, peut être un simple miroir métallique ou, de préférence, un miroir de Bragg obtenu selon le procédé déjà décrit.

Le procédé de report d'une couche de silicium d'épaisseur contrôlée peut également être mis à profit pour la réalisation de la cavité d'un émetteur optique.

La fabrication de l'émetteur optique peut comporter :

- la formation sur un support d'un premier miroir de Bragg,
- la formation sur le miroir de Bragg d'une couche de silicium recouvrant une couche d'oxyde de silicium, la couche de silicium étant formée conformément au procédé décrit précédemment, et
- la formation d'un deuxième miroir au-dessus de la couche de silicium.

Le miroir peut être formé directement en contact avec la couche de silicium ou en être séparé par d'autres couches intercalaires.

La couche d'oxyde de silicium peut être formée sur le premier miroir de Bragg avant le report de la couche de silicium. Elle peut aussi, de préférence, être formée directement à la surface de la couche de silicium, c'est-à-dire sur le bloc de silicium, également avant le report.

Le deuxième miroir, tout comme pour la réalisation précédente, peut être un miroir traditionnel ; par exemple, une couche métallique, ou un miroir de Bragg obtenu selon le procédé déjà décrit.

D'autres caractéristiques et avantages de la présente invention ressortiront mieux de la description qui va suivre, en référence aux figures des dessins annexés. Cette description est donnée à titre purement illustratif et non limitatif.

Brève description des figures

- La figure 1 est une coupe schématique d'un bloc de silicium dans lequel est formé une zone de clivage.
- La figure 2 est une coupe schématique d'un assemblage obtenu par report de la structure de la figure 1 sur un support.
- La figure 3 est une coupe schématique de l'assemblage de la figure 2 après clivage selon la zone de clivage.
- La figure 4 est une coupe schématique de l'assemblage de la figure 3 après une opération de finition.
- Les figures 5 et 6 sont des coupes schématiques illustrant des étapes de fabrication d'une structure multicouches $Si/SiO_2$ à partir de l'assemblage de la figure 4.
- Les figures 7, 8 et 9 sont des coupes schématiques illustrant des étapes de fabrication d'un module d'émetteur à microcavité à partir d'une structure multicouches telle qu'obtenue au terme de l'étape représentée à la figure 6.
- Les figures 10, 11 et 12 sont des coupes schématiques illustrant les étapes de fabrication d'un autre module d'émetteur à microcavité.
- Les figures 13, 14 et 15 sont des coupes schématiques illustrant des étapes de fabrication d'encore un autre module d'émetteur à microcavité.

Description détaillée de modes de mise en oeuvre de l'invention

Pour des raisons de simplification, dans les figures décrites ci-après, des parties identiques, similaires ou équivalentes portent les mêmes références. Par ailleurs, la description donnée se rapporte à la fabrication de composants, de dispositifs ou de parties de dispositifs ayant une longueur d'onde de travail ou longueur d'onde centrale donnée, notée λ.

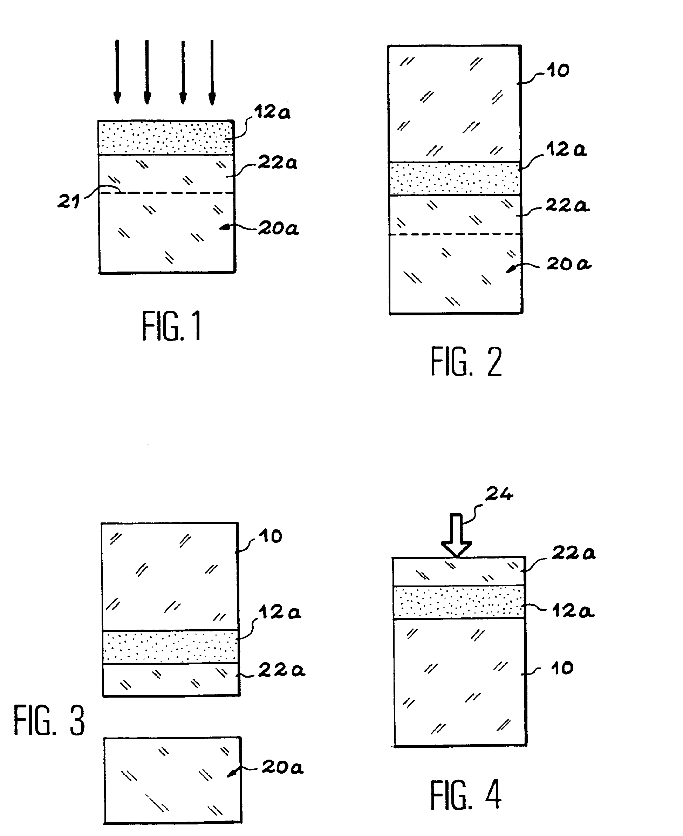

La figure 1 montre un bloc de silicium monocristallin 20a dans lequel sont implantés des ions d'hydrogène $H^+$. L'implantation est représentée sous la forme de flèches.

L'implantation est réalisée avec une dose et une énergie suffisantes pour former, à une profondeur donnée dans le bloc 20a, une zone fragilisée 21, désignée par zone de clivage.

La zone de clivage délimite ainsi dans le bloc de silicium une couche superficielle 22a. La profondeur de la zone de clivage, ajustée avec l'énergie d'implantation est choisie supérieure à l'épaisseur d'une couche de silicium à usage optique que l'on souhaite former.

Ainsi, si on souhaite former une couche d'épaisseur $\dfrac{\lambda}{4n_s}$ où $n_s$ est l'indice de réfraction du silicium, la profondeur d'implantation et donc l'épaisseur de la couche superficielle 22a est choisie supérieure à cette valeur.

On observe également sur la figure 1 que la couche superficielle 22a du bloc 20a est recouverte d'une première couche 12a d'oxyde de silicium. L'épaisseur de la couche d'oxyde est ajustée, par exemple, à $\dfrac{\lambda}{4n_0}$ ou $n_0$ est l'indice de réfraction de l'oxyde de silicium. La couche d'oxyde peut être formée par un procédé de dépôt chimique en phase vapeur ou éventuellement par oxydation thermique du silicium du bloc 20a.

L'épaisseur de la première couche d'oxyde 12a est ajustée par gravure chimique ou mécanochimique par exemple.

La surface libre 13 de la couche d'oxyde de silicium 12a visible à la figure 1 et la surface libre d'un support non représenté, subissent ensuite un traitement permettant leur collage moléculaire ultérieur. Le traitement comporte, par exemple, un nettoyage chimique.

Le support est formé par une plate-forme 10. Il se présente sous la forme d'un substrat massif ou d'un substrat comprenant plusieurs couches de matériaux différents.

Dans l'exemple de la figure 2, décrite ci-après, le support est un bloc de silicium, de verre ou de quartz.

Le collage moléculaire, représenté sur la figure 2, est obtenu en reportant sur le support 10, l'ensemble formé par le bloc de silicium 20a et la couche d'oxyde 12a, de façon à mettre en contact les faces libres de la couche d'oxyde de silicium 12a et la plate-forme 10.

Une opération suivante, illustrée par la figure 3, consiste à effectuer un clivage du bloc de silicium 20a selon la zone de clivage préalablement implantée.

Le clivage peut être assisté par un traitement thermique.

On observe qu'au terme du clivage, la couche superficielle 22 reste solidaire de la plate-forme 10 par l'intermédiaire de la couche d'oxyde de silicium 12a.

Le bloc de silicium 20a qui se détache de la couche superficielle peut éventuellement subir une nouvelle implantation ionique pour y former une nouvelle zone de clivage. Il peut alors être réalisé dans un procédé de report tel que décrit.

La figure 4 montre l'assemblage formé de la plate-forme 10, de la couche d'oxyde 12a et de la couche superficielle 22. L'assemblage est renversé par rapport à la figure 3. Une flèche 24 indique un traitement d'ajustage de l'épaisseur de la couche superficielle.

Dans l'exemple décrit, la couche superficielle 22 présente initialement une épaisseur supérieure à l'épaisseur souhaitée. Ainsi, le traitement d'ajustage de l'épaisseur consiste en un amincissement de la couche. Ce traitement peut avoir lieu par polissage ou encore par une succession d'opérations d'oxydation superficielle et de gravure sélective pour éliminer à chaque fois l'oxyde formé.

Selon une variante de mise en oeuvre du procédé, la couche superficielle peut également être formée initialement avec une épaisseur inférieure à l'épaisseur souhaitée ; ce qui revient à effectuer dans le bloc de silicium une implantation de la zone de clivage à une profondeur inférieure à $\dfrac{\lambda}{4n_S}$.

Dans ce cas, l'étape d'ajustage de l'épaisseur de la figure 4 consiste en une augmentation de l'épaisseur de la couche. Celle-ci peut être réalisée par croissance de silicium à la surface de la couche superficielle.

Le procédé décrit ci-avant peut être itéré pour la réalisation de composants ou de dispositifs optiques particuliers. Quelques exemples en sont exposés ci-après.

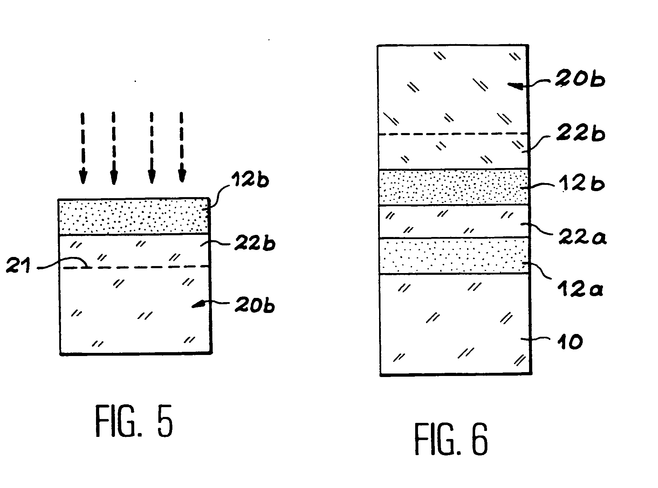

La figure 5 montre la formation d'une nouvelle couche d'oxyde de silicium 12b sur un bloc de silicium monocristallin 20b. Tout comme le bloc 20a de la figure 1, le bloc de silicium 20b présente une zone de clivage 21 qui en délimite une couche superficielle 22b. La couche de clivage est formée par implantation d'ions hydrogène.

Par ailleurs, le procédé de formation de la nouvelle couche d'oxyde de silicium 12b est identique à celui exposé pour la formation de la première couche d'oxyde 12a.

L'épaisseur de la nouvelle couche d'oxyde est également ajustée à une valeur de $\dfrac{\lambda}{4n_O}$.

La figure 6 montre le report du nouveau bloc de silicium de la figure 5 sur la structure de la figure 4.

La surface de la couche superficielle d'oxyde de silicium 12b, recouvrant le bloc de silicium 20b, est mise en contact et collée par adhésion moléculaire sur la couche de silicium 22b dont l'épaisseur a été préalablement ajustée.

On observe que, dans cette structure, l'assemblage formé par la plate-forme 10, la première couche d'oxyde de silicium 12a et la première couche de silicium 22a est utilisée comme support pour la formation d'une nouvelle alternance de couches SiO$_2$/Si.

Un nouveau clivage permet de séparer le bloc 20b de sa couche superficielle 22b qui reste solidaire de la couche d'oxyde de silicium 12b sous-jacente.

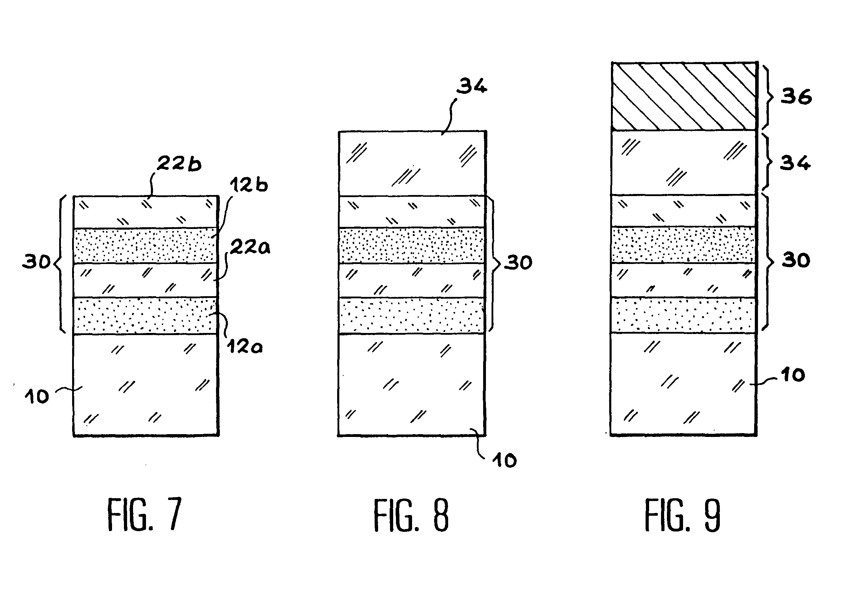

Un ajustage de l'épaisseur de la couche de silicium superficielle 22b permet d'obtenir une structure telle que représentée à la figure 7.

Cette structure comporte sur la plate-forme 10 un empilement alterné de couches d'oxyde de silicium et de silicium dont l'épaisseur optique est ajustée en fonction d'une longueur d'onde donnée. Cet empilement, repéré avec la référence 30 constitue un miroir de Bragg.

Bien entendu, selon des propriétés de réflexion souhaitées, le nombre d'alternances SiO$_2$/Si du miroir de Bragg peut être augmenté en répétant les étapes du procédé décrit ci-dessus.

La figure 8 montre une étape d'un procédé de fabrication d'un composant optique incluant le miroir de Bragg 30 de la structure de la figure 7.

L'étape de la figure 8 comprend la formation sur la dernière couche de silicium superficielle 22b d'une cavité optique 34 en un matériau actif.

La cavité 34 est réalisée par croissance d'un ou plusieurs matériaux choisis parmi Si, SiGe, SiGeC, SiC. Ces matériaux peuvent contenir des impuretés dopantes telles que des impuretés d'erbium constituant des éléments actifs.

La cavité peut se présenter sous la forme d'un bloc massif, sous la forme d'une ou de plusieurs couches minces, sous la forme de structure à boîtes quantiques ou encore sous la forme d'une structure multicouche associant des couches de différents matériaux choisis parmi ceux énumérés ci-dessus. Son épaisseur est ajustée lors de la croissance du matériau en fonction de la longueur d'onde de travail λ.

Une cavité de silicium peut comporter, par exemple, une succession de couches de silicium et de couches d'alliage SiGe très fines. Les couches de SiGe, dont l'épaisseur est de l'ordre de 5 nm, ne créent pas de dislocations dues à un désaccord de maille cristalline mais peuvent constituer des puits quantiques.

De la même façon, le désaccord de mailles entre des couches de silicium et des couches de germanium, très fines, peut résulter en la formation d'îlots de germanium qui constituent les boîtes quantiques. Ces îlots augmentent considérablement la capacité de la cavité 34 à émettre de la lumière.

Le composant optique est complété, comme le montre la figure 9, par la mise en place sur la cavité 34 d'un deuxième miroir 36.

Le deuxième miroir 36 peut être, par exemple, un miroir de Bragg conventionnel obtenu par un dépôt successif de couches de SiO$_2$/Si selon un procédé de dépôt chimique en phase vapeur assisté par plasma dit PECVD (Plasma Enhanced Chemical Vapor Deposition).

Le deuxième miroir 36 peut également être réalisé selon le procédé déjà décrit pour la réalisation du premier miroir de Bragg 30.

Enfin, le deuxième miroir 36 peut également être un miroir classique métallique obtenu par dépôt d'un film métallique. Un tel dépôt peut être réalisé par évaporation.

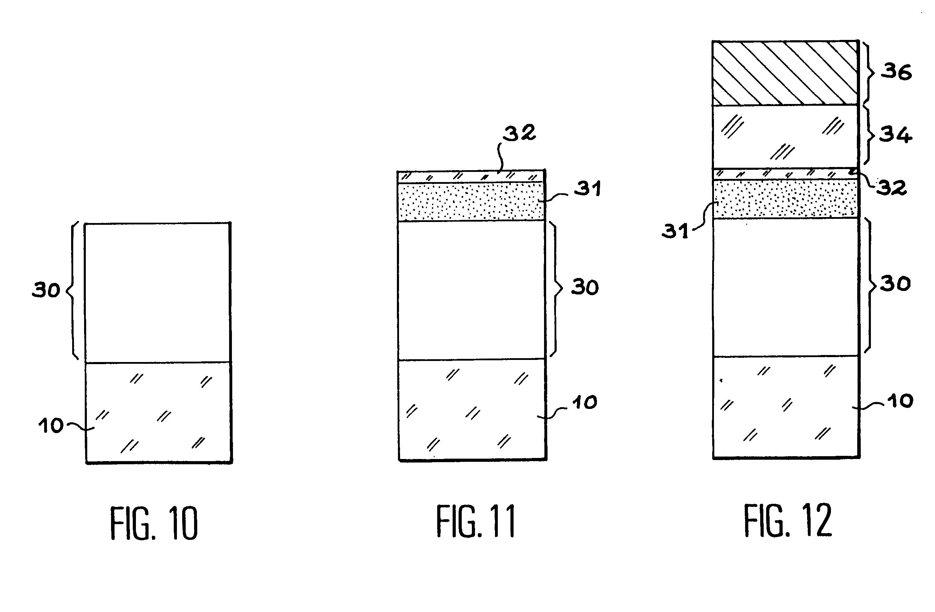

Les figures 10 à 12 montrent encore une autre mise en oeuvre possible de l'invention.

La figure 10 montre une première étape consistant à former un miroir 30 sur une plate-forme 10 en silicium.

Le miroir 30 peut être un miroir de Bragg tel que décrit en référence à la figure 7 ou un miroir d'un autre type à l'instar du miroir 36 de la figure 9, décrit ci-avant.

Une deuxième étape, illustrée par la figure 11, comprend la formation sur le premier miroir 30 d'une couche d'oxyde de silicium 31 et d'une couche de silicium 32 qui recouvre la couche d'oxyde.

La couche de silicium 32 provient d'un bloc de silicium dont elle constitue une couche superficielle. Ce bloc peut éventuellement être recouvert de la couche d'oxyde. La couche de silicium, éventuellement recouverte de la couche d'oxyde, est alors reportée selon le procédé décrit en référence aux figures 2 et 3.

La couche d'oxyde de silicium 31 peut également être formée directement sur le premier miroir 30 et recouverte ensuite par report de la couche de silicium 32.

L'épaisseur de la couche de silicium 32 reportée n'est toutefois pas ajustée à une épaisseur correspondant à une épaisseur optique pour la longueur d'onde choisie.

Elle est en effet utilisée ici comme un support permettant de promouvoir la croissance ultérieure de matériaux actifs pour former une cavité optique. L'épaisseur de la couche de silicium 32 est ainsi de préférence très faible. Son épaisseur est comprise, par exemple, entre 5 et 200 nm.

La figue 12 montre la croissance d'un matériau actif pour former une cavité optique 34 de la façon déjà décrite.

On peut considérer que la couche de silicium 32 fait partie de la cavité 34 pour le calcul et l'ajustage de l'épaisseur optique de cette dernière.

Enfin, la cavité est recouverte d'un deuxième miroir 36 comparable au miroir correspondant de la figure 9.

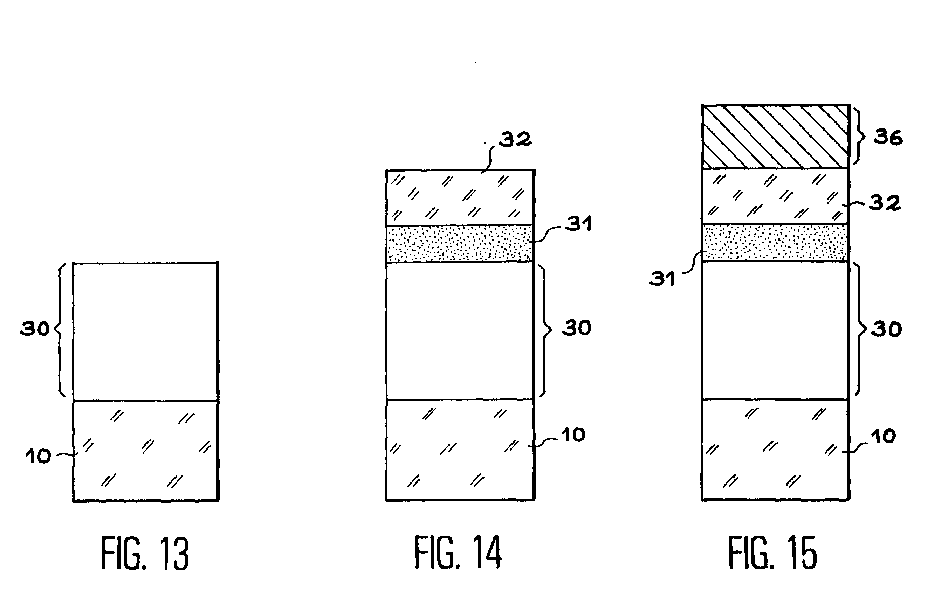

Les figures 13 à 15 illustrent encore une autre possibilité d'application de l'invention pour la réalisation d'un composant optique.

Les figures 13 et 14 représentent des structures sensiblement identiques aux figures 10 et 11 et obtenues selon les mêmes procédés. La description plus détaillée de ces figures est donc omise ici.

On observe toutefois que la couche de silicium 32 reportée sur le premier miroir 30 et recouvrant la couche d'oxyde 31 est bien plus épaisse que celle de la figure 11.

La couche de silicium 32, dont l'épaisseur est contrôlée par la profondeur de la zone de clivage dans le bloc de silicium dont elle provient, est choisie supérieure à l'épaisseur optique souhaitée pour le composant optique.

L'épaisseur de la couche de silicium 32 est ajustée par polissage ou par gravure pour former une cavité optique.

Cette cavité peut être recouverte par un deuxième miroir 36 comme le montre la figure 15.

Les composants décrits ci-dessus peuvent être associés entre eux ou associés à d'autres composants optiques ou électroniques sur un même substrat.

De même lorsque les cavités optique des composants décrits sont utilisés comme émetteurs de lumière, elle peuvent être associées à des moyens de pompage optique ou électrique appropriés et connus en soi.

## DOCUMENTS CITES

Des références concernant les documents cités dans le texte ci-dessus de même que des documents concernant un arrière-plan technologique sont donnés ci-après.

*(1)*

"Epitaxy-ready Si/SiO2 Bragg reflectors by multiple separation-by-implanted-oxygen" Appl. Phys. Lett. 69(25), 16 dec. 96 de Yukari Ishikawa et al.

*(2)*

FR-A-2 681 472

*(3)*

"Giant enhancement of luminescence intensity in Erdoped Si/SiO2 resonant cavities" Appl. Phys. Lett. 61(12), 21 Sept. 1992 de E.F. Schubert et al.

*(4)*

"Silicon intersubband lasers" Superlattices and Microstructures, vol. 23, n° 2, 1998 de Richard A. Soref.

**(5)**

"Prospects for novel Si-based optoelectronic devices : unipolar and p-i-p-i lasers" Thin Solid Films 294 (1997) 325-329 de Richard A. Soref

**(6)**

"Characterization of bond and etch-back silicon-on-insulator wafers by photoluminescence under ultraviolet excitation" Appl. Phys. Lett. 70(2), 13 January 1977 de M. Tajima et al.

*(7)*

"Luminescence due to electron-hole condensation in silicon-on-insulator" Journal of Applied Physics, volume 84, n° 4, 15 August 1998 de Michio Tajima et al.

**Revendications**

1. Procédé de formation sur un support (10) d'une couche de silicium (22a, 22b, 32, 34) à usage optique présentant une épaisseur optique déterminée, comportant les étapes suivantes :

   a) le collage moléculaire sur le support, déjà équipé ou non d'autres couches, d'un bloc de silicium (20a, 20b), le bloc de silicium comprenant une couche superficielle (22a, 22b, 32, 34), délimitée par une zone de clivage (21) sensiblement parallèle à sa surface, et présentant une épaisseur supérieure, respectivement inférieure à ladite épaisseur déterminée, et le bloc de silicium étant recouvert d'une couche d'oxyde de silicium (12a, 12b), mise en contact avec le support lors du collage,
   b) le clivage du bloc de silicium selon la zone de clivage pour en détacher la couche superficielle, solidaire du support, et
   c) l'amincissement, respectivement l'augmentation de l'épaisseur, de ladite couche superficielle jusqu'à atteindre une épaisseur sensiblement égale à ladite épaisseur déterminée.

2. Procédé selon la revendication 1, dans lequel on utilise lors de l'étape a) un bloc de silicium dont la couche superficielle (22a, 22b) présente une épaisseur qui est supérieure à l'épaisseur déterminée et, dans lequel, lors de l'étape c), l'amincissement de la couche superficielle comporte au moins une opération d'oxydation suivie d'au moins une gravure, et/ou une opération de polissage.

3. Procédé selon la revendication 1, dans lequel on utilise lors de l'étape a) un bloc de silicium (20a, 20b) dont la couche superficielle (22a, 22b) présente une épaisseur qui est inférieure à l'épaisseur déterminée et, lors de l'étape c), on augmente l'épaisseur de la couche superficielle par croissance cristalline.

4. Procédé selon la revendication 1, dans lequel, avant l'étape a), on effectue une implantation d'hydrogène à travers une face (23) du bloc de silicium pour former dans le bloc (20a, 20b) une zone fragilisée (21), s'étendant sensiblement selon un plan parallèle à sa surface et formant la zone de clivage, l'énergie de l'implantation étant ajustée pour former la zone de clivage à une profondeur supérieure, respectivement inférieure, à ladite épaisseur déterminée.

5. Procédé de fabrication d'un miroir de Bragg de longueur d'onde $\lambda$ sur un support, dans lequel on forme un empilement de couches comprenant alternativement au moins une couche d'oxyde de silicium (12a, 12b) d'épaisseur optique $\dfrac{\lambda}{4n_O}$, où $n_O$ désigne l'indice de réfraction de l'oxyde de silicium et au moins une couche de silicium (22a, 22b) présentant une épaisseur optique de $\dfrac{\lambda}{4n_S}$, où $n_S$ désigne l'indice de réfraction du silicium, et dans lequel ladite couche de silicium est formée selon le procédé de la revendication 1.

6. Procédé selon la revendication 5, dans lequel on forme ladite couche d'oxyde de silicium par un procédé de dépôt chimique en phase vapeur ou par oxydation thermique du silicium.

7. Procédé de fabrication d'un composant optique avec une longueur d'onde de travail $\lambda$ comprenant :

   - la formation d'un miroir de Bragg (30) selon le procédé de la revendication 5,
   - la formation par croissance cristalline sur le miroir de Bragg de la couche de matériau actif (34) pour former une cavité,
   - la formation sur la cavité d'un deuxième miroir (36).

8. Procédé selon la revendication 7, dans lequel le matériau actif est choisi parmi le silicium pur, le silicium contenant une impureté, le carbure de silicium SiC et les alliages $Si_xGe_{1-x}$, avec $0<x<1$.

9. Procédé selon la revendication 7, comprenant la formation du deuxième miroir par dépôt d'une couche métallique sur la cavité.

**10.** Procédé selon la revendication 7, comprenant la réalisation du deuxième miroir sous la forme d'un miroir de Bragg conformément à la revendication 5.

**11.** Procédé de fabrication d'un composant optique comprenant la formation sur un support d'un miroir de Bragg selon le procédé de la revendication 5, suivie de la formation d'une cavité optique par croissance cristalline d'au moins un matériau actif.

**12.** Procédé de fabrication d'une structure optique comprenant :

- la formation sur un support d'un premier miroir de Bragg (30),
- la formation sur le miroir de Bragg d'une couche de silicium (32) conformément au procédé de la revendication 1, et
- la formation d'un deuxième miroir (36) au-dessus de la couche de silicium.

**13.** Procédé selon la revendication 12, dans lequel les premier et deuxième miroirs sont des miroirs de Bragg réalisés conformément au procédé de la revendication 5.

**14.** Procédé selon la revendication 12, dans lequel la couche de silicium (34) présente une épaisseur optique égale à $\dfrac{\lambda}{4n_S}$ où $\lambda$ est la longueur d'onde de travail de la structure optique et $n_s$ l'indice de réfraction du silicium.

**15.** Procédé selon la revendication 12, dans lequel, avant la formation du deuxième miroir, on fait croître sur la couche de silicium une ou plusieurs couches (34) de matériau actif choisi parmi SiGe, SiGeC et SiC, pour former une cavité optique.

**Claims**

**1.** Process for the formation of a silicon layer (22a, 22b, 32, 34) for optical purposes with a given optical thickness, on a support (10), comprising the following steps :

a) Molecular bonding of a silicon block (20a, 20b) on the support on which there may or may not already be other layers, the silicon block having a surface layer (22a, 22b, 32, 34) delimited by a cleavage area (21) approximately parallel to its surface, and with a thickness greater than (or less than) the said determined thickness, and the silicon block being covered by a silicon oxide layer (12a, 12b) brought into contact with the support during bonding,
b) cleavage of the silicon block along the cleavage area to detach the surface layer fixed to the support from it, and
c) thinning (or thickening) the said surface layer until a thickness approximately equal to the said determined thickness, is obtained.

**2.** Process according to claim 1, in which the thickness of the surface layer (22a, 22b) of the silicon block used in step a) is greater than the determined thickness, and in which thinning of the surface layer in step c) comprises at least one oxidation operation followed by at least one etching operation and/or one polishing operation.

**3.** A process according to claim 1, in which the thickness of the surface layer (22a, 22b) of the silicon block (20a, 20b) used in step a) is less than the determined thickness, and the thickness of the surface layer is increased by crystalline growth during step c).

**4.** Process according to claim 1, in which a hydrogen implantation is performed before step a) through one of the faces (23) of the silicon block to form an embrittled area (21) in the block (20a, 20b) extending approximately along a plane parallel to the said face and forming the cleavage area, the implantation energy being adjusted to form the cleavage area at a depth which is either greater than or less than the determined thickness.

**5.** Process for manufacturing a Bragg mirror with wavelength $\lambda$ on a support, in which a stack of layers is formed comprising alternately at least one layer of silicon oxide (12a, 12b) with optical thickness $\dfrac{\lambda}{4n_o}$, where $n_o$ denotes the refraction index of the silicon oxide, and at least one silicon layer (22a, 22b) with an optical thickness equal to $\dfrac{\lambda}{4n_S}$, wherein $n_s$ is the refraction index of silicon, and in which the said silicon layer is formed according to the process mentioned in claim 1.

**6.** Process according to claim 5, in which the silicon oxide layer may be formed by chemical vapor deposition using a Plasma Enhanced Chemical Vapor Deposition (PECVD) process.

**7.** Process for manufacturing an optical component with a wording wavelength λ comprising :

> - the formation of a Bragg mirror (30) according to the process described in claim 5,
> - formation of a layer of active material (34) on the Bragg mirror by crystalline growth, to form a cavity,
> - formation of a second mirror (36) on the cavity.

8. Process according to claim 7, in which the active material is chosen from among pure silicon, silicon containing one impurity, silicon carbide SiC and $Si_xGe_{1-x}$ alloys where $0 < x < 1$.

9. Process according to claim 7, comprising the formation of a second mirror by deposition of a metallic layer on the cavity.

10. Process according to claim 7, including the construction of the second mirror in the form of a Bragg mirror according to claim 5.

11. Process for manufacturing an optical component including the formation of a Bragg mirror on a support according to the process in claim 5, followed by the formation of an optical cavity by crystalline growth of at least one active material.

12. Process for the manufacture of an optical structure comprising :

> - formation of a first Bragg mirror (30) on a support,
> - formation of a silicon layer (32) on the Bragg mirror, according to the process according to claim 1, and
> - formation of a second mirror (36) above the silicon layer.

13. Process according to claim 12, in which the first and second mirrors are Bragg mirrors made according to the process in claim 5.

14. Process according to claim 12, in which the optical thickness of the silicon layer (34) is equal to $\dfrac{\lambda}{4n_S}$ , where λ is the working wavelength of the optical structure and $n_S$ is the refraction index of the silicon.

15. Process according to claim 12, in which one or several layers (34) of active material chosen among SiGe, SiGeC and SiC are grown on the silicon layer before the formation of the second mirror, to form an optical cavity.

**Patentansprüche**

1. Verfahren zur Bildung einer Siliziumschicht (22a, 22b, 32, 34) zu optischen Zwecken mit einer bestimmten optischen Dicke auf einem Träger (10), das die folgenden Schritte umfasst:

> a) das molekulare Kleben eines Siliziumblocks (20a, 20b) auf den bereits mit anderen Schichten versehenen oder nicht versehenen Träger, wobei der Siliziumblock eine Oberflächenschicht (22a, 22b, 32, 34) aufweist, die durch eine zu seiner Oberfläche im Wesentlichen parallele Spaltungsfläche (21) begrenzt wird und eine Dicke über beziehungsweise unter der bestimmten Dicke aufweist und der Siliziumblock mit einer Siliziumoxidschicht (12a, 12b) bedeckt ist, die während des Klebens mit dem Träger in Kontakt gebracht wird,
> b) die Spaltung des Siliziumblocks entlang der Spaltungsfläche, um die an dem Träger befestigte Oberflächenschicht davon abzutrennen, und
> c) das Verringern beziehungsweise Vergrößern der Dicke der Oberflächenschicht bis zum Erreichen einer Dicke, die der bestimmten Dicke im Wesentlichen gleich ist.

2. Verfahren gemäß Anspruch 1, bei dem während des Schritts a) ein Siliziumblock verwendet wird, dessen Oberflächenschicht (22a, 22b) eine Dicke aufweist, die größer als die bestimmte Dicke ist, und bei dem während des Schritts c) die Verdünnung der Oberflächenschicht wenigstens einen Oxidationsvorgang aufweist, der von wenigstens einem Ätzen und/oder einem Poliervorgang gefolgt wird.

3. Verfahren gemäß Anspruch 1, bei dem während des Schritts a) ein Siliziumblock (20a, 20b) verwendet wird, dessen Oberflächenschicht (22a, 22b) eine Dicke aufweist, die kleiner als die bestimmten Dicke ist, und während des Schritts c) die Dicke der Oberflächenschicht durch Kristallwachstum vergrößert wird.

4. Verfahren gemäß Anspruch 1, bei dem vor dem Schritt a) eine Wasserstoffimplantation durch eine Fläche (23) des Siliziumblocks ausgeführt wird, um in dem Block (20a, 20b) eine versprödete Zone (21) zu bilden, die sich im Wesentlichen entlang einer Ebene parallel zu ihrer Oberfläche erstreckt und die Spaltungsfläche bildet, wobei die Implantationsenergie zum Bilden der Spaltungsfläche mit einer größeren beziehungsweise kleineren Tiefe als der besagten bestimmten Dicke eingestellt wird.

5. Verfahren zur Herstellung eines Bragg-Spiegels der Wellenlänge λ auf einem Träger, bei dem ein Stapel aus Schichten gebildet wird, der abwechselnd wenigstens eine Siliziumoxidschicht (12a, 12b) der optischen Dicke $\dfrac{\lambda}{4n_o}$ umfasst, worin $n_o$ den Brechungsindex des Siliziumoxids bezeichnet, und wenigstens eine Siliziumschicht (22a, 22b) umfasst, die eine optische Dicke von $\dfrac{\lambda}{4n_s}$ aufweist, worin $n_s$ den Brechungsindex des Siliziums bezeichnet, und bei dem die Siliziumschicht gemäß dem Verfahren des Anspruchs 1 gebildet wird.

6. Verfahren gemäß Anspruch 5, bei dem die Siliziumoxidschicht durch ein Verfahren der chemischen Dampfphasenabscheidung oder durch thermische Siliziumoxidoxidation gebildet wird.

7. Verfahren zur Herstellung eines optischen Bauteils mit einer Arbeitswellenlänge λ umfassend:

   - die Bildung eines Bragg-Spiegels (30) gemäß dem Verfahren des Anspruchs 5,
   - die Bildung der Schicht (34) aus aktivem Material durch Kristallwachstum auf dem Bragg-Spiegel zum Bilden eines Hohlraums,
   - die Bildung eines zweiten Spiegels (36) auf dem Hohlraum.

8. Verfahren gemäß Anspruch 7, bei dem das aktive Material aus reinem Silizium, eine Verunreinigung enthaltendem Silizium, Siliziumcarbid SiC und Legierungen $Si_xGe_{1-x}$, worin $0 < x < 1$, ausgewählt wird.

9. Verfahren gemäß Anspruch 7 umfassend die Bildung des zweiten Spiegels durch Auftrag einer Metallschicht auf den Hohlraum.

10. Verfahren gemäß Anspruch 7 umfassend die Herstellung des zweiten Spiegels in Form eines Bragg-Spiegels gemäß Anspruch 5.

11. Verfahren zur Herstellung eines optischen Bauteils umfassend die Bildung eines Bragg-Spiegels auf einem Träger gemäß dem Verfahren des Anspruchs 5, gefolgt von der Bildung eines optischen Hohlraums durch Kristallwachstum wenigstens eines aktiven Materials.

12. Verfahren zu Herstellung einer optischen Struktur umfassend:

   - die Bildung eines ersten Bragg-Spiegels (30) auf einem Träger,
   - die Bildung einer Siliziumschicht (32) auf dem Bragg-Spiegel gemäß dem Verfahren des Anspruchs 1 und
   - die Bildung eines zweiten Spiegels (36) über der Siliziumschicht.

13. Verfahren gemäß Anspruch 12, bei dem die ersten und zweiten Spiegel gemäß dem Verfahren des Anspruchs 5 hergestellte Bragg-Spiegel sind.

14. Verfahren gemäß Anspruch 12, bei dem die Siliziumschicht (34) eine optische Dicke aufweist, die gleich $\dfrac{\lambda}{4n_s}$ ist, worin λ die Arbeitswellenlänge der optischen Struktur und $n_s$ der Brechungsindex des Siliziums ist.

15. Verfahren gemäß Anspruch 12, bei dem man vor der Bildung des zweiten Spiegels eine oder mehrere Schichten (34) aus aktivem Material, das aus SiGe, SiGeC und SiC ausgewählt wird, unter Bilden eines optischen Hohlraums auf der Siliziumschicht wachsen lässt.

FIG. 1

FIG. 2

FIG. 3

FIG. 4

12b

22b

21

20b

FIG. 5

20b

22b

12b

22a

12a

10

FIG. 6

EP 1 070 371 B1

FIG. 7

FIG. 8

FIG. 9

30

10

**FIG. 10**

32

31

30

10

**FIG. 11**

36

34

32

31

30

10

**FIG. 12**

FIG. 13

FIG. 14

FIG. 15

EP 1 070 371 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2681472 A

**Littérature non-brevet citée dans la description**

- **YUKARI ISHIKAWA.** Epitaxy-ready Si/SiO2 Bragg reflectors by multiple separation-by-implanted-oxygen. *Appl. Phys. Lett.,* 16 Décembre 1996, vol. 69 (25
- **E.F. SCHUBERT.** Giant enhancement of luminescence intensity in Erdoped Si/SiO2 resonant cavities. *Appl. Phys. Lett.,* 21 Septembre 1992, vol. 61 (12
- **RICHARD A. SOREF.** Silicon intersubband lasers. *Superlattices and Microstructures,* 1998, vol. 23 (2
- **RICHARD A. SOREF.** Prospects for novel Si-based optoelectronic devices : unipolar and p-i-p-i lasers. *Thin Solid Films,* 1997, vol. 294, 325-329
- **M. TAJIMA.** Characterization of bond and etch-back silicon-on-insulator wafers by photoluminescence under ultraviolet excitation. *Appl. Phys. Lett.,* 13 Janvier 1977, vol. 70 (2
- **MICHIO TAJIMA.** Luminescence due to electron-hole condensation in silicon-on-insulator. *Journal of Applied Physics,* 15 Août 1998, vol. 84 (4